# EUROPEAN PATENT APPLICATION

(11) **EP 4 749 303 A1**
(43) Date of publication of application: **27.05.2026**
(21) Application number: 25774835.0
(22) Date of filing: 22.01.2025
(51) Int. Cl.: G01R 31/367, G01R 31/371, G01R 31/3842, G01R 19/25, H04L 12/40, H04L 69/08, H02J 7/00

(54) **PERFORMANCE TEST SYSTEM FOR BATTERY MANAGEMENT SYSTEM**

(30) Priority: 19.03.2024 KR 20240037835
(71) Applicant: LG Energy Solution, Ltd., Seoul 07335 (KR)
(72) Inventor: JUNG, Jin Kyu, Daejeon 34122 (KR)
(74) Representative: Plasseraud IP
(86) International application number: PCT/KR2025/001238
(87) International publication number: WO 2025/198171

(57) **Abstract**

A BMS performance test system may include a battery pack simulator (BPS) implemented to simulate a plurality of battery cells of a target battery device to be simulated and providing a battery measurement information; a test device for generating a BPS test signal based on a test information including the battery measurement information; and a CAN analysis device that converts the BPS test signal into a first CAN signal to be transmitted to the BPS, and receives a second CAN signal including the battery measurement information from the BPS. The BPS may include a measuring instrument for providing the battery measurement information; and a communication converter that receives the first CAN signal from the CAN analysis device, converts the first CAN signal according to the communication method of the measuring instrument to generate a first simulation control signal to be provided to the measuring instrument, and receives the battery measurement information from the measuring instrument to be transmitted to the CAN analysis device.

## Description

### [Technical Field]

### CROSS-REFERENCE TO RELATED APPLICATION

This application claims priority to and the benefit of Korean Patent Application No. 10-2024-0037835 filed with the Korean Intellectual Property Office on March 19, 2024, the entire contents of which are incorporated herein by reference.

The present disclosure relates to a performance test system for a battery management system.

### [Background Art]

To evaluate a performance of a battery management system (BMS), a battery pack simulator (BPS) equipment is used. The BPS equipment generates a simulation information about a voltage, a current, a temperature, etc. of the battery pack and/or battery cell and provides it to the BMS and a test device, and the test device may receive a response to the simulation information from the BMS and verify the performance of the BMS based on this.

Since the communication methods are different for each measuring instrument that makes up the BPS device, the test device may control the measuring instrument and check the status thereof through a Ul program provided by a manufacturer of the measuring instrument. Since the performance of the UI program for each manufacturer of the measuring instrument and the maintenance capabilities of the UI program for the measuring instrument are different, it is difficult to operate the test device stably.

### [Disclosure]

### [Technical Problem]

It is to provide a BMS performance test system that may stably operate test devices without a relationship with the manufacturers of the measuring instruments that make up the BPS.

### [Technical Solution]

A BMS performance test system according to an embodiment may include a battery pack simulator (BPS) implemented to simulate a plurality of battery cells of a target battery device to be simulated and provide a battery measurement information, a test device for generating a BPS test signal based on a test information including the battery measurement information, and a controller area network (CAN) analysis device that is configured to convert the BPS test signal into a first CAN signal to be transmitted to the BPS, and receive a second CAN signal including the battery measurement information from the BPS. The BPS may include a measuring instrument configured to provide the battery measurement information, and a communication converter that is configured to receive the first CAN signal from the CAN analysis device, convert the first CAN signal according to a communication method of the measuring instrument to generate a first simulation control signal to be provided to the measuring instrument, and receive the battery measurement information from the measuring instrument to be transmitted to the CAN analysis device.

The BPS may further include a cell power simulator that generates and outputs a plurality of cell voltages of the plurality of battery cells. The communication converter may generate a second simulation control signal for the plurality of cell voltages based on a CAN message of the first CAN signal by using a communication method of the cell power simulator to be provided to the cell power simulator, when a CAN message ID of the first CAN signal indicates a simulation of the plurality of cell voltages for the plurality of battery cells.

The cell power simulator may provide, as a status information, a cell voltage information measuring the plurality of cell voltages output by the cell power simulator or a cell voltage information representing the plurality of cell voltages according to the second simulation control signal to the communication converter. The communication converter device may generate the second CAN signal including the cell voltage information to be transmitted to the CAN analysis device.

The measuring instrument may be an analog digital converter (ADC) circuit that measures a plurality of cell currents flowing in the plurality of battery cells. The communication converter may generate the first simulation control signal, which instructs a plurality of cell current measurement based on a CAN message of the first CAN signal by a communication method of the ADC circuit to be provided to the ADC circuit, when the first CAN signal instructs the plurality of cell current measurement for the plurality of battery cells.

The ADC circuit may provide cell current information based on the plurality of cell currents to the communication converter. The communication converter may generate the second CAN signal including the cell current information to be transmitted to the CAN analysis device.

The measuring instrument may be a pack current measuring instrument that measures pack current flowing through the battery pack of the target battery device. The communication converter may generate the first simulation control signal, which instructs a pack current measurement based on a CAN message of the first CAN signal, using a communication method of the pack current measuring instrument to be provided to the pack current measuring instrument, when the first CAN signal instructs the pack current measurement.

The pack current measuring instrument may generate the pack current according to the first simulation control signal and transmit a battery pack current information according to the first simulation control signal to the communication converter as a status information. The communication converter may generate the second CAN signal including the battery pack current information to be transmitted to the CAN analysis device.

The measuring instrument may be a temperature measuring instrument that measures a cell temperature of the plurality of battery cells of the target battery device. The communication converter may generate the first simulation control signal indicating a plurality of battery cell temperatures based on a CAN message of the first CAN signal using a communication method of the temperature measuring instrument to be provided to the temperature measuring instrument, when the first CAN signal indicates a temperature measurement for the plurality of battery cells.

The temperature measuring instrument may generate a temperature detection information indicating a plurality of cell temperatures according to the first simulation control signal, and transmit the temperature detection information according to the first simulation control signal to the communication converter as a status information. The communication converter may generate the second CAN signal including the temperature detection information to be transmitted to the CAN analysis device.

The measuring instrument may be a load measuring instrument that generates a load current information of the target battery device. The communication converter may generate the first simulation control signal, which indicates a load current value based on a CAN message of the first CAN signal, using a communication method of the load measuring instrument, and to be provided to the load measuring instrument when the first CAN signal indicates the simulation of a load current flowing in the load connected to the target battery device.

The load measuring instrument may generate the load current information according to the first simulation control signal and transmit the load current information to the communication converter as a status information. The communication converter may generate the second CAN signal including the load current information to be transmitted to the CAN analysis device.

The measuring instrument may be a relay measuring instrument that generates a signal indicating an opening or closing of each of a plurality of relays of the target battery device. The communication converter may generate the first simulation control signal including an information about the opening or closing of each of the plurality of relays based on a CAN message of the first CAN signal by a communication method of the relay measuring instrument to be provided to the relay measuring instrument when the first CAN signal indicates the opening and closing of the plurality of relays.

The relay measuring instrument may generate a relay opening/closing information according to the first simulation control signal and transmits the relay opening/closing information to the communication converter as a status information. The communication converter may generate the second CAN signal including the relay opening/closing information to be transmitted to the CAN analysis device.

The BMS performance test system may further include an electric power supply device generating an output power. The communication converter may generate the first simulation control signal, which indicates an output power value based on a CAN message of the first CAN signal, using a communication method of the electric power supply device to be provided to the electric power supply device when the first CAN signal indicates an output power simulation.

The test device may generate a BMS control signal that instructs a control instruction for the battery management system for the target battery device to be transmitted to the CAN analysis device, and the CAN analysis device may convert the BMS control signal into a CAN signal to generate a third CAN signal to be transmitted to the battery management system, and receive a fourth CAN signal from the battery management system, which instructs the battery management system to perform a control in response to the battery measurement information.

The test device may determine necessary controls to be performed by the battery management system based on the battery measurement information, and determine whether the battery management system is normal based on a result of comparing an execution control indicated by the fourth CAN signal.

The first CAN signal may include a CAN message ID and a CAN message, and specify a control instruction and control target for the BPS according to the CAN message ID, and the CAN message may include a simulation information necessary for simulation operation to be performed by the control target of the BPS according to the control instruction.

The second CAN signal may include a CAN message ID and a CAN message, and a type of the battery measurement information is determined according to the CAN message ID, and the CAN message includes values provided by the measuring instrument.

The CAN analysis device may convert the BPS test signal into the first CAN signal according to a CAN message ID for BPS control and a protocol for the CAN message. The communication converter may convert the battery measurement information into the second CAN signal according to the protocol.

The protocol may include a first region for the CAN message ID for transmitting the first CAN signal from the CAN analysis device to the BPS; and a second region for a CAN message ID for transmitting the second CAN signal from the BPS to the CAN analysis device.

### [Advantageous Effects]

The present disclosure provides the BMS performance test system that may perform the tests by using the CAN communication without any relationship to the communication method of the measuring instruments that make up the BPS in the BMS performance test.

### [Description of the Drawings]

FIG. 1 is a block diagram showing a BMS performance test system according to an embodiment.
FIG. 2 is a view showing a configuration of a BPS device according to an embodiment.
FIG. 3 is a block diagram showing a configuration of a cell power simulator according to an embodiment.
FIG. 4 is a circuit diagram schematically showing a battery pack simulation device shown in FIG. 3.
FIG. 5 is a block diagram showing a pack current measuring instrument according to an embodiment.
FIG. 6 is a block diagram showing a temperature measuring instrument according to an embodiment.

### [Mode for Invention]

The drawings accompanying in the specification are provided only in order to allow exemplary embodiments disclosed in the present specification to be easily understood and are not to be interpreted as limiting the spirit disclosed in the present specification, and it is to be understood that the present disclosure includes all modifications, equivalents, and substitutions without departing from the scope and spirit of the present disclosure

Terms including ordinal numbers such as first, second, and the like will be used only to describe various components, and are not interpreted as limiting these components. The terms are only used to differentiate one component from other components.

It will be further understood that terms "comprise" or "have" used in the present specification specify the presence of stated features, numerals, steps, operations, components, parts, or a combination thereof, but do not preclude the presence or addition of one or more other features, numerals, steps, operations, components, parts, or a combination thereof.

A performance test system for verifying functions of the BMS of an electric vehicle (EV) and a light electric vehicle (LEV) may utilize a CAN communication. The BMS performance test system includes a test device, and the test device may transmit control instructions, control targets, and simulation information for controlling the simulation operation of the BPS to the BPS through the CAN communication, and may receive a measurement information and a status information provided from the BPS through the CAN communication. The test device may transmit the control instructions to the BMS via the CAN communication and receive the responses for the control instructions from the BMS via the CAN communication. The BPS may include a communication converter for utilizing the CAN communication. The test device may analyze the performance of the BMS without a separate UI program by using an information received from the BPS and an information received from the BMS via the CAN communication. At this time, the physical channel for the CAN communication between the test device and the BPS and the physical channel for the CAN communication between the test device and the BMS may be separated from each other. In addition, the CAN communication protocol between the test device and the BPS may be standardized to transmit/receive an information. Then, the test device may stably analyze the performance of the BMS by using the BPS without having a relationship with the manufacturers of the measuring instruments that make up the BPS or the BPS manufacturer. In the present disclosure, the BMS performance test system may include a CAN analysis device providing the CAN communication between the test device and the BPS and the CAN communication between the test device and the BMS.

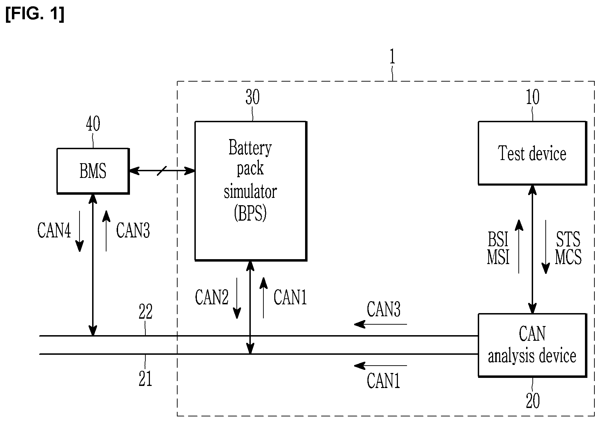

FIG. 1 is a block diagram showing a BMS performance test system according to an embodiment.

The system 1 includes a test device 10, a CAN analysis device 20, and a BPS 30. The system 1 may test the performance of the BMS 40. The BMS 40 may be a BMS that constitutes a battery system applied to EVs and LEVs.

The test device 10 may perform a built-in test program and provide a test information through the test program. The test information may include a battery measurement information to be simulated and measured by the BPS 30 and specifications regarding the battery measurement information. The battery measurement information is a status information about a battery device (hereinafter, a target battery device) to be simulated by the BPS 30, and may include the information about cell voltages of a plurality of cells constituting the target battery device, the temperature of the battery and/or cells, the current flowing through the battery, etc. The specifications for the battery measurement information may include an information on whether the pack current measurement results are expressed in a current unit or a voltage unit (a voltage generated by a pack current flowing through a shunt resistor), and whether the temperature of the battery cell is expressed in a temperature unit or a voltage unit (a voltage across two terminals of a thermistor).

The test device 10 may receive the test information through a user interface or receive the test information through a wireless communication. For example, the test device 10 may obtain the test information from a log data of the BMS mounted on the vehicle via a wired and wireless communication.

The test device 10 may generate a BPS test signal STS including a control instruction, a control object, and a simulation information that control the simulation operation of the BPS 30 based on the test information. The test device 10 may determine a control instruction according to a control target and an operation to be simulated by the control target among a cell power device and a plurality of measuring instruments constituting the BPS 30, and may obtain the simulation information necessary for the simulation operation to be performed by the control target according to the control instruction. For example, test device 10 may receive the simulation information input from an external source or extract the simulation information from the log data of the BMS.

The test device 10 may transmit the BPS test signal STS to the CAN analysis device 20. The test device 10 may generate a BMS control signal MCS, which instructs the control instruction for the BMS 40, and transmit it to the CAN analysis device 20. The control instruction for the BMS 40 may be an instruction requesting an information (hereinafter, a BMS status information) about the operation performed by the BMS 40 in response to the battery measurement information obtained from the BPS 30. The battery measurement information may include a status information about the battery pack and the battery cell, such as the battery pack current, the battery cell voltage, the battery cell current, and the battery cell temperature, generated by the BPS 30 performing the simulation operation on the battery pack and the battery cell according to the BPS test signal STS.

The CAN analysis device 20 converts the BPS test signal STS and the BMS control signal MCS provided from the test device 10 into CAN signals to generate a first CAN signal CAN1 and a third CAN signal CAN3, and transmits them to the BPS 30 and the BMS 40 through two CAN buses 21 and 22. For example, the CAN analysis device 20 may transmit the first CAN signal CAN1 to the BPS 30 via the CAN bus 21 and the third CAN signal CAN3 to the BMS 40 via the CAN bus 22. The CAN bus 22 between the CAN analysis device 20 and the BMS 40, and the CAN bus 21 between the CAN analysis device 20 and the BPS 30 are separated. In this way, the CAN bus 21 and the CAN bus 22 that are the physical channels are separated from each other, so that a standardized CAN message ID for the BPS 30 control and a protocol for the CAN message may be provided. Accordingly, the CAN message ID and the CAN message according to the standardized protocol may be used without a relationship with the manufacturer of the BPS 30.

The CAN analysis device 20 may convert the BPS test signal STS into the CAN message ID and the CAN message. The CAN analysis device 20 may determine the corresponding CAN message ID in the protocol defined based on the control target and the control instruction indicated by the BPS test signal STS, and generate the simulation information as the CAN message. The CAN analysis device 20 may combine CAN message ID and the CAN message to generate the first CAN signal CAN1 and transmit it to the BPS 30 via the CAN bus 21.

The test device 10 may receive a battery measurement information BSI and a BMS status information MSI from the CAN analysis device 20. The test device 10 may test the performance of the BMS by analyzing the BMS status information MSI. The communication method between the test device 10 and the CAN analysis device 20 may be one of various wired and wireless communication methods. For example, if the test device 10 is implemented as a computing device, the test device 10 and the CAN analysis device 20 may transmit/receive an information in a computer communication manner.

The BMS 40 may perform the control on the target battery device in response to the battery measurement information provided by the BPS 30. The BMS 40 receives third CAN signal CAN3, and, in response to third CAN signal CAN3, generates a fourth CAN signal CAN4 indicating an information on the control performed by the BMS 40, i.e. the BMS status information MSI, and transmits it to the CAN analysis device 20. The CAN analysis device 20 may convert the fourth CAN signal CAN4 to generate the BMS status information MSI. For example, if the BMS 40 performs the cell balancing according to the battery measurement information, the BMS 40 may generate a fourth CAN signal CAN4 indicating the BMS status information MSI indicating the cell balancing performance and transmit it to the CAN analysis device 20. The CAN analysis device 20 may convert the fourth CAN signal CAN4 to generate the BMS status information MSI indicating the cell balancing performance and transmit it to the test device 10. The test device 10 may determine the control required to be performed by the BMS 40 based on the battery measurement information BSI, and determine that the corresponding function of BMS 40 is in a normal state based on the result of comparing the performance control indicated by the BMS status information MSI. For example, if it is determined that the control to be performed by the BMS 40 is determined as the cell balancing based on the battery measurement information BSI, and if the control to be performed indicated by the BMS status information MSI is the cell balancing, the test device 10 may determine that the BMS 40 is in the normal state. In contrast, if the control to be required and the control to be performed are different, it may be determined that the corresponding function of the BMS 40, for example, the cell balancing function is an abnormal.

The BPS 30 may convert control instructions and simulation information into a communication method corresponding to the control target indicated by the first CAN signal CAN1 to generate the simulation control signal that controls the control target, and provide it to the control target. The BPS 30 may perform the simulation operation according to the simulation control signal, generate a second CAN signal CAN2 representing measurement values (e.g., a plurality of cell voltages, cell balancing currents) for the battery measurement information provided by the performed simulation operation and the status information of the BPS 30, and provide the second CAN signal CAN2 to the CAN analysis device 20. The status information of the BPS 30 includes an information for checking whether each component of the BPS 30 has normally received the CAN message according to the CAN message **ID** from the communication converter 390. Any of the configurations of the BPS 30 may transmit the received simulation information to the communication converter 390 as the status information of the corresponding configuration.

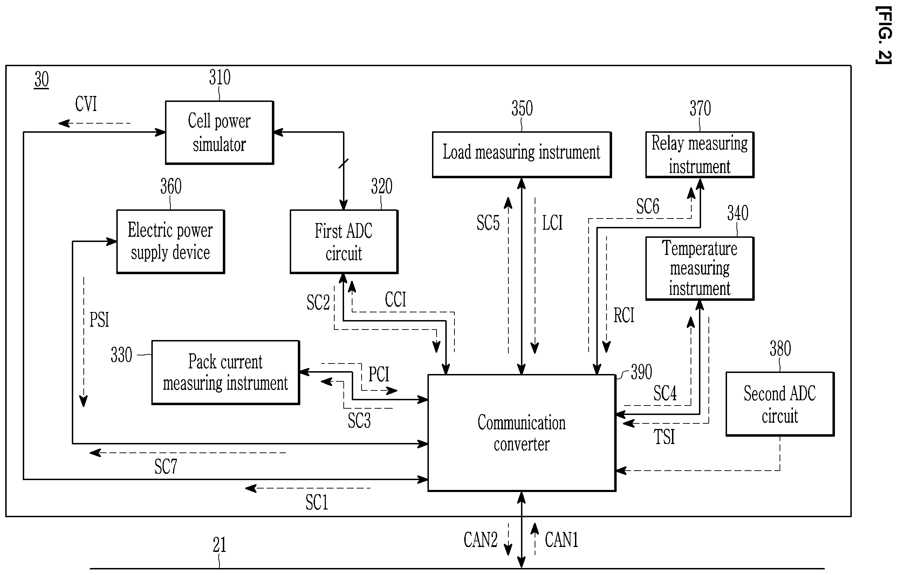

FIG. 2 is a view showing a configuration of a BPS device according to a certain embodiment.

The BPS 30 may include a cell power simulator 310, a first analog digital converter (ADC) circuit 320, a pack current measuring instrument 330, a temperature measuring instrument 340, a load measuring instrument 350, a relay measuring instrument 370, an electric power supply device 360, a second analog digital converter (ADC) circuit 380, and a communication converter 390. The cell power simulator 310, the first ADC circuit 320, the pack current measuring instrument 330, the temperature measuring instrument 340, the load measuring instrument 350, the relay measuring instrument 370, and the electric power supply device 360 illustrated in FIG. 2 are examples of the components of the BPS 30, but are not limited thereto.

The communication converter 390 may determine the corresponding configuration among the configurations 310, 320, 330, 340, 350, 360, and 370 of the BPS 30 according to the CAN message ID in the first CAN signal CAN1, convert the CAN message according to the communication method that the corresponding configuration may receive to generates the simulation control signal, and transmit the simulation control signal to the corresponding configuration. The simulation control signal may include the simulation information necessary for the simulation operation to be performed by the corresponding configuration. The communication converter 390 may convert the battery measurement information and the status information of the BPS 30 received from the components 310, 320, 330, 340, 350, 360, 370, and 380 of the BPS 30 into the second CAN signal CAN2 and transmit them to the CAN analysis device 20. The communication converter 390 may perform the CAN communication with the CAN analysis device 20 via the CAN bus 21.

When the CAN message ID indicates the simulation of the plurality of cell voltages for the plurality of battery cells, the communication converter 390 may generate the simulation control signal including the information about the plurality of cell voltages of the plurality of battery cells based on the CAN message to the cell power simulator 310. At this time, the communication converter 390 may generate a simulation control signal SC1 according to the communication method of the cell power simulator 310. For example, if the cell power simulator 310 is an RS485 serial communication method, the communication converter 390 may generate the simulation control signal SC1 including a bit data indicating the plurality of cell voltages to be suitable for the RS485 serial communication. The technology for converting the CAN communication signal into a signal of one of various communication methods and the technology for converting a signal of one of various communication methods into the CAN communication signal through the communication converter 390 may be implemented using known technologies.

The cell power simulator 310 may be implemented to simulate the battery pack voltage according to the charging and discharging of each of the plurality of battery packs, and the cell voltage and the cell current for each of the plurality of battery cells of each of the plurality of battery packs according to the simulation control signal SC1. The cell power simulator 310 may divide the plurality of battery packs constituting the battery device (hereinafter, the target battery device) to be simulated into a pack unit, and may individually control the cell voltage and the cell current of each of the plurality of battery cells of each battery pack.

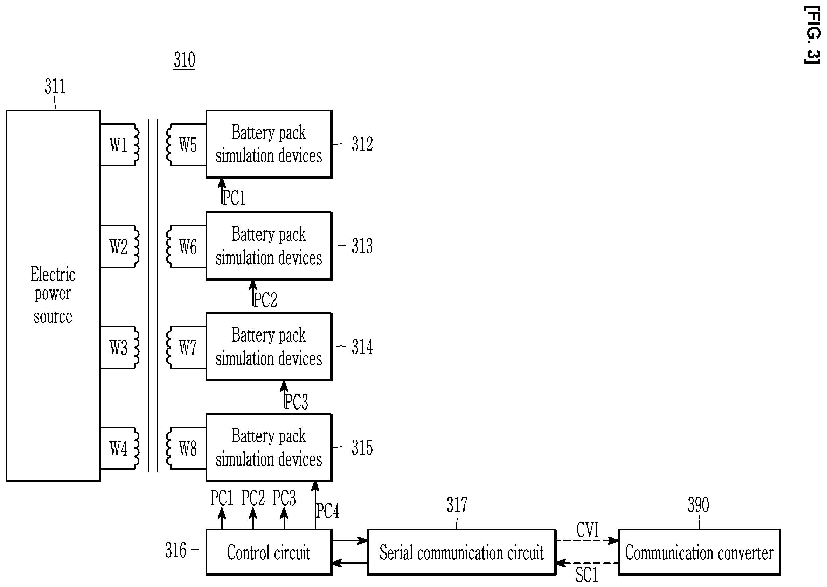

FIG. 3 is a block diagram showing a configuration of a cell power simulator according to some embodiment.

The cell power simulator 310 illustrated in FIG. 3 is an example of simulating a plurality of cells. FIG. 3 shows four battery pack simulation devices, but this is only an example and does not limit the disclosure.

As shown in FIG. 3, the cell power simulator 310 may include an electric power source 311, a plurality of battery pack simulation devices 312 to 315, a control circuit 316, and a serial communication circuit 317.

The electric power source 311 may supply an electric power from an electric power system or an external power source, convert the electric power into a voltage range suitable for the cell power simulator 310, and supply it to the plurality of battery pack simulation devices 312 to 315. The electric power source 311 and the plurality of battery pack simulation devices 312 to 315 are insulated ed and coupled. The electric power source 311 may include a plurality of primary windings W1, W2, W3, and W4, and each of the plurality of battery pack simulation devices 312 to 315 may include a plurality of secondary windings W5, W6, W7, and W8. In the charge operation, the electric power supplied by electric power source 311 may be transferred from each of the plurality of primary windings W1, W2, W3, and W4, which are insulated and coupled, to each of the plurality of secondary windings W5, W6, W7, and W8. In the discharge operation, the electric power discharged by each of the plurality of battery pack simulation devices 312 to 315 may be transferred from each of the plurality of secondary windings W5, W6, W7, and W8 to each of the plurality of primary windings W1, W2, W3, and W4.

The serial communication circuit 317 may receive the simulation control signal SC1 from the communication converter 390 and transmit it to the control circuit 316. The control circuit 316 may generate a plurality of power control signals PC1 to PC4 for controlling the operation of the plurality of battery pack simulation devices 312 to 315 according to the simulation control signal SC1 and provide the plurality of power control signals to the plurality of battery pack simulation devices 312 to 315. The simulation control signal SC1 may include a plurality of battery cell voltage values of each of the plurality of battery pack simulation devices 312 to 315, and the control circuit 316 may generate a plurality of power control signals PC1 to PC4, respectively, based on the simulation control signal SC1 so that each of the plurality of battery pack simulation devices 312 to 315 generates a plurality of cell voltages.

The control circuit 316 may transmit a cell voltage information CVI, which measures a plurality of cell voltages output by the cell power simulator 310, or a cell voltage information CVI, which represents the plurality of cell voltages according to the received simulation control signal SC1, to the serial communication circuit 317 as the status information of the cell power simulator 310. The serial communication circuit 317 may transmit the cell voltage information CVI to the communication converter 390 by using the RS485 serial communication method. The communication converter 390 may convert the received cell voltage information CVI to generate the second CAN signal CAN2 and transmit the second CAN signal CAN2 to the CAN analysis device 20.

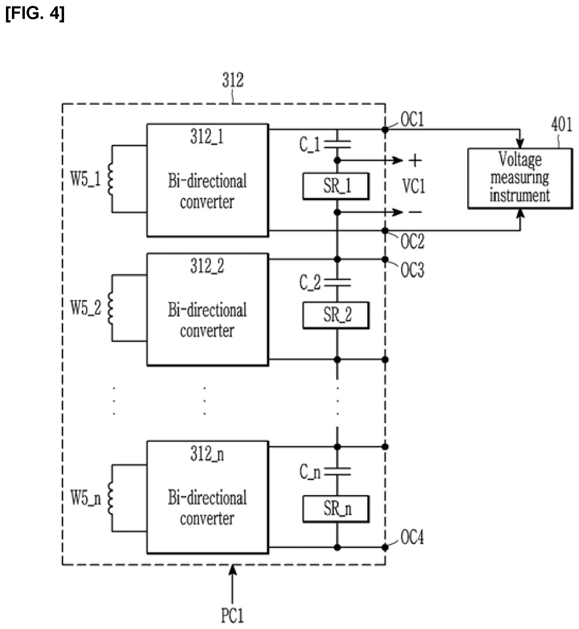

FIG. 4 is a circuit diagram schematically showing a battery pack simulation device shown in FIG. 3.

FIG. 4 shows a schematic circuit diagram of the battery pack simulation device 312, one of a plurality of battery pack simulation devices illustrated in FIG. 3. The remaining battery pack simulation devices 313, 314, and 315 may each be implemented in the same manner as the circuit illustrated in FIG. 4.

The secondary windings W5 may include a plurality of windings W5_1, W5_2, ..., W5_n depending on the number of battery cells (n, n is a natural number greater than or equal to 2) constituting the battery pack simulation device 312.

The battery pack simulation device 312 may include a plurality of bi-directional converters 312_1, 312_2, ..., 312_n and a plurality of capacitors C_1, C_2, ..., C_n. Two input terminals of each of the plurality of bi-directional converters 312_1, 312_2, ..., 312_n are connected to both terminals of each of the plurality of windings W5_1, W5_2, ..., W5_n, and a plurality of capacitors C_1, C_2, ..., C_n are connected along with a plurality of shunt resistors SR_1, SR_2, ..., SR_n between two output terminals of each of the plurality of bi-directional converters 312_1, 312_2, ..., 312_n. The voltage between two output terminals of each of the plurality of bi-directional converter 312_1, 312_2, ..., 312_n may represent each of a plurality of cell voltages, respectively. A plurality of two output terminals (e.g., OC1, OC2) of a plurality of bi-directional converters 312_1, 312_2, ..., 312_n may be connected to the BMS 40 and provide the plurality of cell voltages to the BMS 40.

In FIG. 4, to simulate the series connection of the plurality of battery cells that constitute the battery pack, the output terminal (e.g., OC2) having a lower potential of two output terminals of each of the plurality of bi-directional converters 312_1, 312_2, ..., 312_n may be connected to the output terminal (e.g., OC3) having a higher potential among two output terminals of the adjacent bi-directional converter. The voltage difference between the highest potential output terminal OC1 and the lowest potential output terminal OC4 among the plurality of bi-directional converters 312_1, 312_2, ..., 312_n may represent the battery pack voltage. The connection relationship between the plurality of bi-directional converters 312_1, 312_2, ..., 312_n may be determined according to the connection relationship of the plurality of battery cells constituting the target battery pack.

Each of the plurality of bi-directional converters 312_1, 312_2, ..., 312_n may convert the energy transferred through the plurality of windings W5_1, W5_2, ..., W5_n during the charge simulation to generate the plurality of cell voltages. Each of the plurality of capacitors C_1, C_2, ..., C_n may provide the plurality of cell voltages by filtering the output of each of the plurality of bi-directional converters 312_1, 312_2, ..., 312_n. Each of the plurality of bi-directional converters 312_1, 312_2, ..., 312_n may convert the energy charged to each of the plurality of capacitors C_1, C_2, ..., C_n during the discharge simulation and transfer the electric power to each of the plurality of windings W5_1, W5_2, ..., W5_n. The electric power operation of each of the plurality of bi-directional converters 312_1, 312_2, ..., 312_n may be controlled according to the power control signal PC1. For example, the power control signal PC1 may be implemented as a set of signals that control the electric power operation of each of the plurality of bi-directional converters 312_1, 312_2, ..., 312_n.

The cell current flows through each of the plurality of shunt resistors SR_1, SR_2, ..., SR_n, and the voltage between two terminals of each of the plurality of shunt resistors SR_1, SR_2, ..., SR_n may be at a level according to each cell current. For example, the voltage difference VC1 across the shunt resistor SR_1 may represent the cell current flowing in the battery cell.

When the cell power simulator 310 wants to directly measure the plurality of cell voltages as the status information, the cell power simulator 310 may include a plurality of voltage measuring devices connected to each output terminal of the plurality of bi-directional converters 312_1, 312_2, ..., 312_n to measure the plurality of cell voltages. As shown in FIG. 4, the voltage measuring device 401 may be connected between two output terminals OC1 and OC2 of the bi-directional converter 312_1.

In this way, the cell power simulator 310 may simulate a plurality of cell voltages and a plurality of cell currents of each of the plurality of battery cells of the battery pack.

The BMS 40 may receive the plurality of cell voltages and the battery pack voltage provided from the cell power simulator 310, and perform the monitoring operation to measure the plurality of cell voltages.

If the CAN message ID of the first CAN signal CAN1 and the CAN message indicate the plurality of cell current measurement for the plurality of battery cells, the communication converter 390 may generate the simulation control signal SC2 indicating the plurality of cell current measurements according to the CAN message and transmit it to the first ADC circuit 320. If the first ADC circuit 320 uses the CAN communication method, the communication converter 390 may generate simulation control signal SC2 according to the CAN message. In contrast, if the communication method of the first ADC circuit 320 is the RS232 serial communication method, the communication converter 390 may convert the CAN message into the simulation control signal SC2 according to the RS 232 serial communication and transmit it to the first ADC circuit 320. The first ADC circuit 320 may measure the plurality of cell currents flowing through the plurality of battery cells according to the simulation control signal SC2.

The first ADC circuit 320 may transmit a cell current information CCI that an analog signal measuring the cell current flowing through each of the plurality of battery cells simulated by the cell power simulator 310 according to the simulation control signal SC2 is convert into a digital signal and to the communication converter 390. The first ADC circuit 320 may convert the voltages across the plurality of shunt resistors SR_1, SR_2, ..., SR_n (e.g., VC1 in FIG. 4) into a plurality of digital signals to generate the cell current information CCI, and transmit the cell current information CCI to the communication converter 390 by using an RS232 serial communication method. The communication converter 390 may convert the cell current information CCI into the plurality of CAN messages ID and the plurality of CAN messages, and transmit the second CAN signal CAN2 including them to the CAN analysis device 20. The communication converter 390 may group digital signals included in the cell current information CCI into a predetermined unit, assign the CAN message ID for each group, and combine the CAN message including the digital signals of the predetermined unit constituting each group to each CAN message ID. The test device 10 may receive the cell current information CCI as the battery measurement information BSI when the cell balancing is in progress for any of the plurality of battery cells, and confirm the cell balancing operation.

When the CAN message ID indicates the pack current measurement flowing through the battery pack, the communication converter 390 may generate a simulation control signal SC3 that indicates the pack current measurement to the pack current measuring instrument 330 based on the CAN message. At this time, the communication converter 390 may generate the simulation control signal SC3 according to the communication method of the pack current measuring instrument 330. For example, if the pack current measuring instrument 330 is a LAN communication method, the communication converter 390 may generate the simulation control signal SC3 indicating the pack current according to the CAN message for the battery pack defined by the CAN message ID according to the LAN communication method. The CAN message ID may also include an instruction for a unit that measures the pack current. Typically, the unit for measuring the pack current may be a current unit or a voltage unit (a voltage generated when the pack current flows through a shunt resistor). Therefore, the CAN message IC may indicate one of the current unit or the voltage unit.

The pack current measuring instrument 330 may generate the pack current according to the simulation control signal SC3 and generate the pack current signal by measuring the pack current. The BMS 40 may receive the pack current signal of the current unit in the actual battery system or the voltage (the voltage unit) across the shunt resistor through which the battery pack current flows. Therefore, the pack current signal generated by the pack current measuring instrument 330 may indicate the battery pack current or the voltage across the shunt resistor caused by the battery pack current flowing through the shunt resistor. The pack current measuring instrument 330 may provide the pack current signal to the BMS 40. The pack current measuring instrument 330 may transmit the battery pack current information PCI according to the simulation control signal SC3 to the communication converter 390 as the status information of the pack current measuring instrument 330. The status information of the pack current measuring instrument 330 is an information for checking whether the pack current measuring instrument 330 has normally received the CAN message according to the CAN message ID from the communication converter 390. The communication converter 390 may convert the battery pack current information PCI to generate the second CAN signal CAN2 and transmit the second CAN signal CAN2 to the CAN analysis device 20.

Under the condition that the BMS 40 is implemented to receive the pack current signal of the voltage unit as input, if the CAN message ID indicates the pack current signal by the current unit, the pack current measuring instrument 330 may convert the pack current signal of the current unit by the voltage unit and provide it to the BMS 40.

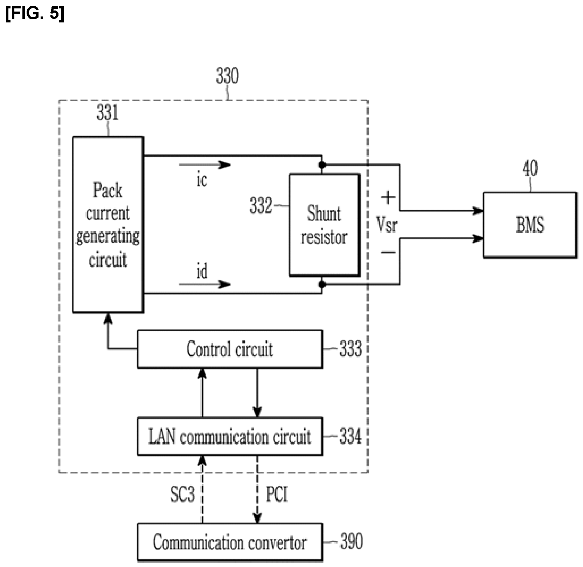

FIG. 5 is a block diagram showing a pack current measuring instrument according to one embodiment.

FIG. 5 is a block diagram of a pack current measuring instrument that generates a pack current signal of a voltage unit. This is only an example of a pack current measuring instrument and does not limit the disclosure. As shown in FIG. 5, the pack current measuring instrument 330 may include a pack current generating circuit 331, a shunt resistor 332, a control circuit 333, and a LAN communication circuit 334.

The LAN communication circuit 334 may receive the simulation control signal SC3 from the communication converter 390 and transmit the simulation control signal SC3 to the control circuit 333.

The control circuit 333 may control the pack current generating circuit 331 to generate a discharge current id or a charging current ic according to the magnitude of the simulation control signal SC3. The discharge current may flow in the opposite direction with the direction of the charging current as a reference. The current generated by the pack current generating circuit 331 may flow through the shunt resistor 332.

The voltage Vsr across both terminals generated by the current flowing through the shunt resistor 332 may be provided to the BMS 40 as a pack current signal.

The control circuit 333 collects the battery pack current values from the simulation control signal SC3 as the status information, generates the battery pack current information PCI, and transmits it to the LAN communication circuit 334. The LAN communication circuit 334 may transmit the battery pack current information PCI to the communication converter 390.

If the CAN message ID indicates the temperature measurement for the plurality of battery cells, the communication converter 390 may generate the simulation control signal SC4 indicating the plurality of battery cell temperatures to the temperature measuring instrument 340 based on the CAN message. At this time, the communication converter 390 may generate the simulation control signal SC4 according to the communication method of the temperature measuring instrument 340. For example, if the temperature measuring instrument 340 uses an RS485 serial communication method, the communication converter 390 may generate the simulation control signal SC4 by serially arranging a bit data indicating the plurality of cell temperatures suitable for the RS485 serial communication. The CAN message ID may also include an instruction for the unit that measures the cell temperature. Generally, a thermistor is used to measure the temperature of the battery cell, and the BMS may receive the temperature corresponding to the resistance value of the thermistor or the voltage across the thermistor as a temperature information. If the CAN message ID indicates the temperature information of a temperature unit, the simulation control signal SC4 may indicate a plurality of temperature values. Alternatively, if the CAN message ID indicates the temperature information of the voltage unit, the simulation control signal SC4 may indicate the plurality of voltage values. The temperature measuring instrument 340 may convert the plurality of temperature values or the plurality of voltage values according to the simulation control signal SC4 into an analog signal and provide it to the BMS 40.

The temperature measuring instrument 340 may generate a temperature detection information TSI by collecting the plurality of temperature values or the plurality of voltage values included in the simulation control signal SC4 as the status information of the temperature measuring instrument 340 and transmit it to the communication converter 390. The status information of temperature measuring instrument 340 is an information for checking whether the temperature measuring instrument 340 has normally received the CAN message according to the CAN message ID from communication converter 390. The communication converter 390 may convert the received temperature detection information TSI to generate the second CAN signal CAN2 and transmit the second CAN signal CAN2 to the CAN analysis device 20.

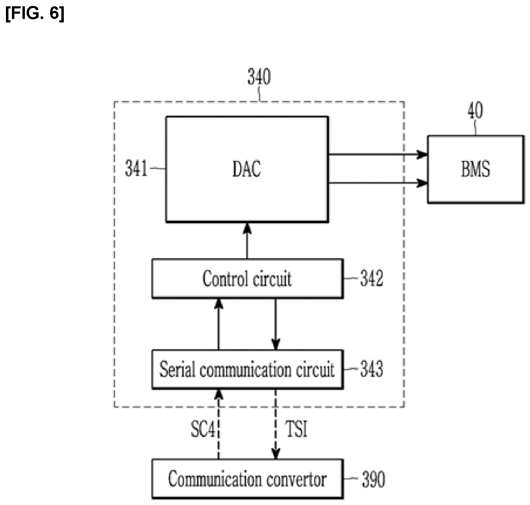

FIG. 6 is a block diagram showing a temperature measuring instrument according to an embodiment.

The block diagram shown in FIG. 6 is an example to help understand the temperature measuring instrument and does not limit the disclosure. As shown in FIG. 6, the temperature measuring instrument 340 may include a digital analog circuit (DAC) 341, a control circuit 342, and a serial communication circuit 343.

The control circuit 342 may generate the temperature values or the voltage values according to the simulation control signal SC4 and provide them to the DAC 341.

The DAC 341 may convert the temperature values or the voltage values into analog signals and output them to the BMS 40. An analog signal having the voltage between two output terminals of the DAC 341 may be provided to the BMS 40.

The control circuit 342 collects the temperature values or the voltage values from the simulation control signal SC4 as the status information to generate the temperature detection information TSI, and transmits it to the serial communication circuit 343. The serial communication circuit 343 may transmit the temperature detection information TSI to the communication converter 390.

The communication converter 390 may generate a simulation control signal SC5 based on the CAN message to the load measuring instrument 350 when the CAN message ID instructs a simulation of a load current flowing through a load connected to the target battery device. When the load measuring instrument 350 uses a LAN communication method, the communication converter 390 may generate the simulation control signal SC5 by configuring a bit data indicating the load current value for the target battery device included in the CAN message according to the LAN signal protocol.

The load measuring instrument 350 may generate the load current values for the target battery device according to the simulation control signal SC5 and provide them to the BMS 40. The load measuring instrument 350 may transmit a load current information LCI according to the load current value included in the simulation control signal SC5 as the status information of the load measuring instrument 350 to the communication converter 390. The communication converter 390 may convert the load current information LCI into a second CAN signal CAN2 and transmit it to the CAN analysis device 20.

The communication converter 390 may generate a simulation control signal SC6 including an information about an opening or closing of each of a plurality of relays based on the CAN message, if the CAN message ID indicates a simulation of opening or closing of the plurality of relays of the target battery device. The plurality of relays may include relays that provide electrical connections between the plurality of battery packs and loads that constitute the target battery device. The corresponding CAN message may include an information about whether a plurality of relays are opened or closed. When the relay measuring instrument 370 is a LAN communication method, the communication converter 390 may generate a simulation control signal SC6 by configuring a plurality of relay control values (bit data) indicating the opening or closing of the plurality of relays included in the CAN message according to the LAN signal protocol.

The relay measuring instrument 370 may generate signals indicating the opening or closing of each of the plurality of relays according to the simulation control signal SC6 and provide them to the BMS 40. The relay measuring instrument 370 may collect the plurality of relay control values included in the simulation control signal SC6 as a status information of the relay measuring instrument 370, generate a relay opening and closing information RCI, and transmit it to the communication converter 390. The communication converter 390 may convert the relay opening and closing information RCI into the second CAN signal CAN2 and transmit it to the CAN analysis device 20.

The communication converter 390 may generate a simulation control signal SC7 based on the CAN message when the CAN message ID indicates an output power simulation. The output power may be the output power of the target battery pack or the charge electric power for charging the target battery pack. When the CAN message ID indicates the output power simulation, the communication converter 390 may generate a simulation control signal SC7 indicating the output power value included in the CAN message. At this time, the communication converter 390 may generate the simulation control signal SC7 according to the communication method of the electric power supply device 360. For example, if the electric power supply device 360 is an RS232 serial communication method, the communication converter 390 may generate the simulation control signal SC7 by serially arranging a bit data indicating the output power or the charge electric power.

The electric power supply device 360 may generate the output power according to the simulation control signal SC7. The electric power supply device 360 may generate the output power measurement signal according to the output power value and transmit it to the BMS 40. The electric power supply device 360 may transmit an electric power information PSI regarding the output power value according to the simulation control signal SC7 as a status information to the communication converter 390. The communication converter 390 may convert the electric power information PSI to generate a second CAN signal CAN2 and transmit it to the CAN analysis device 20.

The second ADC circuit 380 may measure a plurality of gate voltages provided from the BMS 40. The plurality of gate voltages are voltages applied to gates of a plurality of switches that provide charging and discharging paths for the target battery device. The second ADC circuit 380 may measure the plurality of gate voltages and transmit the plurality of measured gate voltage values to the communication converter 390. The communication converter 390 may generate the second CAN signal CAN2 including a plurality of gate voltage values and transmit it to the CAN analysis device 20.

The CAN analysis device 20 may convert the second CAN signal CAN2 received from the communication converter 390 into a communication method suitable for the test device 10 to generate battery measurement information BSI.

Below, the defined protocol for transmitting/receiving the CAN signals between the CAN analysis device 20 and the BPS 30 according to some embodiments is described. The protocol defined in the description below may include a standard region that may be used universally and an extended region that may be arbitrarily defined and used by manufacturers producing devices that constitute the BPS 30.

Table 1 shows a transmitter, a receiver, and a purpose for each ID region of a plurality of CAN messages in each extended region. In Table 1, the CAN message ID is displayed by a hexadecimal.

**(Table 1)**

| CAN message ID range | Transmitter | Receiver | Purpose |
|---|---|---|---|
| 0x00-0x7F | CAN analysis device | BPS | BPS control, BPS setting, BPS debugging |
| 0x80-0xFF | BPS | CAN analysis device | BPS status information |
| 0x700-0x77F | CAN analysis device | BPS | BPS control, BPS setting, BPS debugging |
| 0x780-0x7FF | BPS | CAN analysis device | BPS status information |

The transmitter, the receiver, and the purpose for each CAN message ID in the extended region described in Table 1 may be arbitrarily set by the manufacturer, and Table 1 is only an example and does not limit the disclosure.

Table 2 shows the transmitter, the receiver, and the purpose by each range of the plurality of CAN message IDs in the standard region. In Table 2, the CAN message IDs are displayed in a hexadecimal.

**(Table 2)**

| CAN message ID range | Transmitter | Receiver | Purpose |
|---|---|---|---|
| 0x100-0x2FF | CAN analysis device | BPS | Control target, control instruction, and simulation information for cell voltage control, pack current measurement, cell current measurement, cell temperature measurement, load current measurement, relay opening and closing measurement, output power measurement, charge electric power measurement, the like |
| 0x300-0x4FF | BPS | CAN analysis device | Cell current measurement result |
| 0x500-0x6FF | BPS | CAN analysis device | Status information of BPS |

The status information of the BPS may include a cell voltage information CVI, a pack current information PCI, a temperature detection information TSI, a load current information LCI, a relay opening and closing information RCI, and an electric power information PSI of generating a cell voltage.

First, the CAN message ID range "0x100-0x2FF" is the CAN message ID range that the first CAN signal CAN1 transmitted by the CAN analysis device 20 described above to BPS 30 may have.

Among the CAN message ID ranges 0x100-0x2FF, the plurality of CAN message IDs (0x100-0x140) may specify a predetermined number of units of the battery cells simulated by the BPS 30. For example, "0x100" may be the CAN message ID that specifies the battery cells numbered 1 to 4 among the plurality of battery cells, and "0x101" may be the CAN message ID that specifies the battery cells numbered 5 to 8 among the plurality of battery cells. Each of the plurality of CAN message IDs (0x100-0x140) may be associated with the CAN message including the plurality of cell voltage values for the corresponding predetermined number of units of the battery cells.

Among the CAN message ID ranges 0x100-0x2FF, each of the plurality of CAN message IDs (0x200-0x20A) may identify each of the plurality of battery packs simulated by the BPS 30. Each of the plurality of CAN message IDs (0x200-0x20A) may be associated with the CAN message including the pack voltage value of the corresponding battery pack.

Each of the CAN message IDs (0x240-0x280) among the CAN message ID ranges 0x100-0x2FF may respectively specify the plurality of temperature values or the plurality of voltage values simulated by the BPS 30. Each of the plurality of CAN message IDs (0x240-0x280) may be respectively associated with the CAN message including the corresponding temperature value or voltage value.

Each of the plurality of CAN message IDs (0x2A1-0x2A2) among the CAN message ID ranges 0x100-0x2FF may specify the corresponding relay among the plurality of relays simulated by the BPS 30, and may be associated with the CAN message including the opening and closing values of the corresponding relays.

Among the CAN message ID ranges 0x100-0x2FF, each of the plurality of CAN message IDs (0x2C1-0x2C2) may specify the plurality of output powers simulated by the BPS 30, and may be associated with the CAN message including the corresponding output power values (e.g., the voltage value and the current value).

The plurality of CAN message IDs (0x2DA-0x2DB) among the CAN message ID ranges 0x100-0x2FF may specify the plurality of loads simulated by the BPS 30 and may be associated with the CAN message including the the load value of the corresponding load.

Among the CAN message ID ranges 0x100-0x2FF, the plurality of CAN message IDs (0x100-0x140) may specify a predetermined number of units of the battery cells simulated by the BPS 30. For example, "0x100" may be the CAN message ID that specifies the battery cells numbered 1 to 4 among the plurality of battery cells, and "0x101" may be a CAN message ID that specifies the battery cells numbered 5 to 8 among the plurality of battery cells. Each of the plurality of CAN message IDs (0x100-0x140) may be associated with the CAN message including the plurality of cell voltage values for the corresponding predetermined number of units of the battery cells.

The CAN message ID range "0x300-0x4FF" is the CAN message ID range that the second CAN signal CAN2, which transmits the information measured by BPS 30 described above to CAN analysis device 20, may have.

Among the CAN message ID range 0x300-0x4FF, the plurality of CAN message IDs (0x301-0x308) may specify the plurality of gate voltage values measured by the second ADC circuit 380 in a predetermined number of units. For example, "0x301" may be the CAN message ID that specifies the gate voltage values of the switches numbered 1 to 4 among the plurality of switches, and "0x302" may be the CAN message ID that specifies the gate voltage values of switches numbered 5 to 8 among the plurality of switches. Each of the plurality of CAN message IDs (0x301-0x308) may be associated with the corresponding CAN message. The corresponding CAN message may include a predetermined number of units of the gate voltage values specified by each CAN message ID in the plurality of gate voltage values.

Among the CAN message ID ranges 0x300-0x4FF, the plurality of CAN message IDs (0x401-0x440) may specify the plurality of cell current values according to the cell current information CCI into a predetermined number of units. For example, "0x401" may be the CAN message ID that specifies the cell current values of the battery cells numbered 1 to 4 among the plurality of battery cells, and "0x402" may be the CAN message ID that specifies the cell current values of the battery cells numbered 5 to 8 among the plurality of battery cells. Each of the plurality of CAN message IDs (0x401-0x440) may be associated with the corresponding CAN message. The corresponding CAN message may include a predetermined number of units of the cell current values specified by each CAN message ID in the cell current information CCI. As explained above, the cell current information CCI may be measured and generated by the first ADC circuit 320.

The CAN message ID range "0x500-0x6FF" is the CAN message ID range that the second CAN signal CAN2, which transmits the status information of the BPS 30 described above to the CAN analysis device 20, may have.

Among the CAN message ID range 0x500-0x6FF, each of the plurality of CAN message IDs (0x501-0x540) may specify the plurality of battery cell voltage values according to the cell voltage information CVI in a predetermined number of units. Each of the plurality of CAN message IDs (0x501-0x540) may be associated with the corresponding CAN message. The corresponding CAN message may include a predetermined number of units of cell voltage values, as specified by each CAN message ID in the cell voltage information CVI.

Among the CAN message ID range 0x500-0x6FF, the plurality of CAN message IDs (0x601-0x60A) may each specify the plurality of battery pack current values according to the pack current information PCI. Each of the plurality of CAN message IDs (0x601-0x60A) may be associated with the corresponding CAN message. The corresponding CAN message may include the pack current value specified by each CAN message ID in the pack current information PCI.

Among the CAN message ID ranges 0x500-0x6FF, the plurality of CAN message IDs (0x641-0x670) may each specify the plurality of temperature values according to the temperature detection information TSI. Each of the plurality of CAN message IDs (0x641-0x670) may be associated with the corresponding CAN message. The corresponding CAN message may include the temperature value specified by each CAN message ID in the temperature detection information TSI.

Among the CAN message ID ranges 0x500-0x6FF, the plurality of CAN message IDs (0x6A1-0x6A2) may specify the plurality of relay opening and closing values according to the relay opening and closing information RCI in a predetermined number of units. Each of the plurality of CAN message IDs (0x6A1-0x6A2) may be associated with the corresponding CAN message. The corresponding CAN message may include a number of relay opening and closing values for a predetermined number of units specified by each CAN message ID in the relay opening and closing information RCI.

Each of the plurality of CAN message IDs (0x6C1-0x6C2) in the CAN message ID ranges 0x500-0x6FF may specify each of the plurality of output power values according to electric power information PSI. Each of the plurality of CAN message IDs (0x6C1-0x6C2) may be associated with the corresponding CAN message. The corresponding CAN message may include the output power value specified by each CAN message ID in the electric power information PSI.

Among the CAN message ID ranges 0x500-0x6FF, the plurality of CAN message IDs (0x6D1-0x6D2) may each specify the plurality of load current values according to the load current information LCI. Each of the plurality of CAN message IDs (0x6D1-0x6D2) may be associated with the corresponding CAN message. The corresponding CAN message may include the load current value specified by each CAN message ID in the load current information LCI.

Such protocols for the CAN message ID and the CAN message are examples for understanding the disclosure but is not limited thereto.

The test device 10 may generate the BPS test signal STS based on the test information indicating the abnormal conditions such as an overvoltage, an overcurrent, and a high temperature, and provide it to the BPS 30, and analyze the BMS status information MSI to test whether the BMS is responding normally to the abnormal condition. In this way, the test device 10 may test whether the BMS 40 generates the normal control outputs for various inputs that the BPS 30 provides to the BMS 40 in response to the BPS test signal STS indicating the various status conditions for the target battery device.

While this disclosure has been described in connection with what is presently considered to be practical exemplary embodiments, it is to be understood that the disclosure is not limited to the disclosed embodiments, but, on the contrary, is intended to cover various modifications and equivalent arrangements included within the spirit and scope of the appended claims.

## Claims

1. A battery management system (BMS) performance test system comprising:
a battery pack simulator (BPS) implemented to simulate a plurality of battery cells of a target battery device to be simulated and provide a battery measurement information;
a test device for generating a BPS test signal based on a test information including the battery measurement information; and
a controller area network (CAN) analysis device that is configured to convert the BPS test signal into a first CAN signal to be transmitted to the BPS, and receive a second CAN signal including the battery measurement information from the BPS,
wherein the BPS includes:
a measuring instrument configured to provide the battery measurement information; and
a communication converter that is configured to receive the first CAN signal from the CAN analysis device, convert the first CAN signal according to a communication method of the measuring instrument to generate a first simulation control signal to be provided to the measuring instrument, and receive the battery measurement information from the measuring instrument to be transmitted to the CAN analysis device.

2. The BMS performance test system of claim 1, wherein:
the BPS further includes
a cell power simulator that generates and outputs a plurality of cell voltages of the plurality of battery cells, and
the communication converter generates a second simulation control signal for a plurality of cell voltages based on a CAN message of the first CAN signal by using a communication method of the cell power simulator to be provided to the cell power simulator, when a CAN message ID of the first CAN signal indicates a simulation of the plurality of cell voltages for the plurality of battery cells.

3. The BMS performance test system of claim 2, wherein:
the cell power simulator provides, as a status information, a cell voltage information measuring the plurality of cell voltages output by the cell power simulator or a cell voltage information representing the plurality of cell voltages according to the second simulation control signal to the communication converter, and
the communication converter device generates the second CAN signal including the cell voltage information to be transmitted to the CAN analysis device.

4. The BMS performance test system of claim 1, wherein:
the measuring instrument is an analog digital converter (ADC) circuit that measures a plurality of cell currents flowing in the plurality of battery cells, and
the communication converter generates the first simulation control signal, which instructs a plurality of cell current measurement based on a CAN message of the first CAN signal by a communication method of the ADC circuit to be provided to the ADC circuit, when the first CAN signal instructs the plurality of cell current measurement for the plurality of battery cells.

5. The BMS performance test system of claim 4, wherein:
the ADC circuit provides cell current information based on the plurality of cell currents to the communication converter, and
the communication converter generates the second CAN signal including the cell current information to be transmitted to the CAN analysis device.

6. The BMS performance test system of claim 1, wherein:
the measuring instrument is a pack current measuring instrument that measures pack current flowing through the battery pack of the target battery device, and
the communication converter generates the first simulation control signal, which instructs a pack current measurement based on a CAN message of the first CAN signal, using a communication method of the pack current measuring instrument to be provided to the pack current measuring instrument, when the first CAN signal instructs the pack current measurement.

7. The BMS performance test system of claim 6, wherein:
the pack current measuring instrument generates the pack current according to the first simulation control signal and transmits a battery pack current information according to the first simulation control signal to the communication converter as a status information, and
the communication converter generates the second CAN signal including the battery pack current information to be transmitted to the CAN analysis device.

8. The BMS performance test system of claim 1, wherein:
the measuring instrument is a temperature measuring instrument that measures a cell temperature of the plurality of battery cells of the target battery device, and
the communication converter generates the first simulation control signal indicating a plurality of battery cell temperatures based on a CAN message of the first CAN signal using a communication method of the temperature measuring instrument to be provided to the temperature measuring instrument, when the first CAN signal indicates a temperature measurement for the plurality of battery cells.

9. The BMS performance test system of claim 8, wherein:
the temperature measuring instrument generates a temperature detection information indicating a plurality of cell temperatures according to the first simulation control signal, and transmits the temperature detection information according to the first simulation control signal to the communication converter as a status information, and
the communication converter generates the second CAN signal including the temperature detection information to be transmitted to the CAN analysis device.

10. The BMS performance test system of claim 1, wherein:
the measuring instrument is a load measuring instrument that generates a load current information of the target battery device, and
the communication converter generates the first simulation control signal, which indicates a load current value based on a CAN message of the first CAN signal, using a communication method of the load measuring instrument, and to be provided to the load measuring instrument when the first CAN signal indicates the simulation of a load current flowing in the load connected to the target battery device.

11. The BMS performance test system of claim 10, wherein:
the load measuring instrument generates the load current information according to the first simulation control signal and transmits the load current information to the communication converter as a status information, and
the communication converter generates the second CAN signal including the load current information to be transmitted to the CAN analysis device.

12. The BMS performance test system of claim 1, wherein:
the measuring instrument is a relay measuring instrument that generates a signal indicating an opening or closing of each of a plurality of relays of the target battery device, and
the communication converter generates the first simulation control signal including an information about the opening or closing of each of the plurality of relays based on a CAN message of the first CAN signal by a communication method of the relay measuring instrument to be provided to the relay measuring instrument when the first CAN signal indicates the opening and closing of the plurality of relays.

13. The BMS performance test system of claim 12, wherein:
the relay measuring instrument generates a relay opening/closing information according to the first simulation control signal and transmits the relay opening/closing information to the communication converter as a status information, and
the communication converter generates the second CAN signal including the relay opening/closing information to be transmitted to the CAN analysis device.

14. The BMS performance test system of claim 1, further comprising:
an electric power supply device generating an output power,
the communication converter generates the first simulation control signal, which indicates an output power value based on a CAN message of the first CAN signal, using a communication method of the electric power supply device to be provided to the electric power supply device when the first CAN signal indicates an output power simulation.

15. The BMS performance test system of claim 1, wherein:
the test device generates a BMS control signal that instructs a control instruction for the battery management system for the target battery device to be transmitted to the CAN analysis device, and
the CAN analysis device converts the BMS control signal into a CAN signal to generate a third CAN signal to be transmitted to the battery management system, and receives a fourth CAN signal from the battery management system, which instructs the battery management system to perform a control in response to the battery measurement information.

16. The BMS performance test system of claim 15, wherein:
the test device determines necessary controls to be performed by the battery management system based on the battery measurement information, and determines whether the battery management system is normal based on a result of comparing an execution control indicated by the fourth CAN signal.

17. The BMS performance test system of claim 1, wherein:
the first CAN signal includes a CAN message ID and a CAN message, and specifies a control instruction and control target for the BPS according to the CAN message ID, and the CAN message includes a simulation information necessary for simulation operation to be performed by the control target of the BPS according to the control instruction.

18. The BMS performance test system of claim 1, wherein:
the second CAN signal includes a CAN message ID and a CAN message, and a type of the battery measurement information is determined according to the CAN message ID, and the CAN message includes values provided by the measuring instrument.

19. The BMS performance test system of claim 1, wherein:
the CAN analysis device converts the BPS test signal into the first CAN signal according to a CAN message ID for BPS control and a protocol for a CAN message, and
the communication converter converts the battery measurement information into the second CAN signal according to the protocol.

20. The BMS performance test system of claim 19, wherein:
the protocol includes
a first region for the CAN message ID for transmitting the first CAN signal from the CAN analysis device to the BPS; and
a second region for a CAN message ID for transmitting the second CAN signal from the BPS to the CAN analysis device.
